# EUROPÄISCHE PATENTSCHRIFT

(11) **EP 3 924 208 B1**
(45) Veröffentlichungstag und Bekanntmachung des Hinweises auf die Patenterteilung: **23.11.2022**
(21) Anmeldenummer: 20701549.6
(22) Anmeldetag: 16.01.2020
(51) Int. Cl.: B60K 37/06, H03K 17/96

(54) **BEDIENELEMENT FÜR EIN KRAFTFAHRZEUG**
OPERATING ELEMENT FOR A MOTOR VEHICLE
ÉLÉMENT D'ACTIONNEMENT POUR UN VÉHICULE À MOTEUR

(30) Priorität: 13.02.2019 DE 102019201901
(43) Veröffentlichungstag der Anmeldung: 22.12.2021
(73) Patentinhaber: VOLKSWAGEN AKTIENGESELLSCHAFT, 38440 Wolfsburg (DE)
(72) Erfinder: THRIEN, Markus, 45968 Gladbeck (DE)
(86) Internationale Anmeldenummer: PCT/EP2020/051064
(87) Internationale Veröffentlichungsnummer: WO 2020/164850

(56) Entgegenhaltungen:
- EP-A1- 3 332 482
- DE-A1-102008 046 102

## Beschreibung

Die Erfindung betrifft ein Bedienelement für ein Kraftfahrzeug.

In vielen Kraftfahrzeugen werden zunehmend Bedienelemente verbaut, welche gleichzeitig neben der Schaltfunktion eine Darstellungsfunktion in Form etwa eines Displays aufweisen. Häufig sind dabei bestimmte Funktionen davon abhängig, ob ein angeschlossener Stromkreis aktiv geschaltet ist. Aus dem Stand der Technik sind bereits einige Bedienelemente als bekannt zu entnehmen.

So ist aus der DE 10 2015 008 537 A1 eine Kraftfahrzeug-Bedienvorrichtung mit haptischer Rückmeldung als bekannt zu entnehmen. Die Erfindung betrifft eine Bedienvorrichtung für ein Kraftfahrzeug mit einem Betätigungselement, das zur Erfassung einer Benutzerbetätigung vorgesehen ist und beweglich gelagert ist. Die Betätigungsvorrichtung, die einen Elektromagneten und einen Permanentmagneten sowie eine Steuereinrichtung umfasst, ist derart eingerichtet, sodass sie den Elektromagneten mit einem ersten elektrischen Strom belastet, über den der Elektromagnet den Permanentmagneten mit einer ersten Magnetkraft belastet, die das Betätigungselement aus einer Ruhelage auslenkt. Die Auslenkung des Betätigungselements ist als kurzer Ruck ohne Nachhall erkennbar. Zu diesem Zweck sieht die Erfindung vor, dass ein mechanisches Anschlagelement vorgesehen ist und eine Rückstelleinrichtung mit elastisch verformbarer Konfiguration das Betätigungselement mit einer Rückstellkraft in die Ruheposition gegen das Anschlagelement drückt oder zieht.

Aus der Druckschrift DE 10 2006 057 311 A1 ist eine dreh- und druckbetätigbare Vorrichtung als bekannt zu entnehmen. Die Vorrichtung weist einen rotierenden und druckbetätigbaren Axialabschnitt mit einem Gehäuse und einer Kraftübertragungseinrichtung auf, die mit dem Axialabschnitt verbunden ist. In dem Gehäuse ist eine Rotoreinrichtung drehbeweglich untergebracht, und eine Axialkrafteinrichtung ist indirekt zwischen der Übertragungseinrichtung und der Rotoreinrichtung angeordnet. Eine Druckschaltvorrichtung ist durch Druckbetätigung des axialen Abschnitts gegen eine axiale Kraft betätigbar. Ein Drehwinkelgeber ermittelt Winkelpositionen der Rotorvorrichtung durch eine wechselseitige Wirkung einer sensorerfassbaren Vorrichtung.

Aus der Druckschrift US 2016/0233012 A1 sind polarisierte Magnetantriebe für eine haptische Antwort als bekannt zu entnehmen. Ein polarisiertes elektromagnetisches Stellglied umfasst dabei einen beweglichen Anker, einen Stator und mindestens eine um den Stator gewickelte Spule. Über dem Stator ist mindestens ein Permanentmagnet angeordnet. Wenn ein Strom an die mindestens eine Spule angelegt wird, ist die mindestens eine Spule dazu konfiguriert, einen Magnetfluss von mindestens einem Permanentmagneten in einer Richtung zu reduzieren und einen Magnetfluss von mindestens einem Permanentmagneten in einer anderen Richtung zu erhöhen. Der bewegliche Anker bewegt sich in Richtung des erhöhten magnetischen Flusses.

Aus der Druckschrift EP 2 372 915 B1 ist eine Mensch-Maschine-Schnittstelle, insbesondere für Fahrzeuge als bekannt zu entnehmen. Die Schnittstelle hat eine Übersetzungseinheit zum Verschieben einer taktilen Erfassungseinheit zwischen einer proximalen und einer distalen Position unter der Wirkung einer kontinuierlichen Position. Eine Steuereinheit aktiviert eine Ausrüstung, zum Beispiel einen Aktivator, basierend auf der Erkennung eines taktilen Kontakts in einem Auswahlbereich der Erkennungseinheit. Eine Führungseinheit umfasst eine Stange, die in einem Zylinder verschoben wird. Ein Steuersystem ist in einem Verlängerungsteil der Stange angeordnet. Unter der taktilen Erkennungseinheit ist ein Anzeigegerät installiert, das transparent ist. Ein unabhängiger Anspruch ist auch für ein Verfahren zum Steuern einer Ausrüstung eines Kraftfahrzeugs enthalten.

Aus der Druckschrift DE 10 2011 089 400 A1 ist zudem ein Verfahren zum Betreiben einer Schalteranordnung und eine Schalteranordnung selbst als bekannt zu entnehmen. Ein Verfahren zum Betreiben einer Schalteranordnung mit einer Betätigungsfläche mit einem vorgegebenen Schalterbereich mit einem aktiven Zustand, in dem eine Betätigung des vorgegebenen Schalterbereichs einen Zustand einer zugeordneten Einheit ändert, und einem passiven Zustand, in dem die Betätigung des vorgegebenen Schalterbereichs den Zustand der zugeordneten Einheit nicht ändert, umfasst: - Ermitteln eines Bereichs der Betätigungsfläche, in dem die Betätigung der Schalteranordnung erfolgt, - Vergleichen des ermittelten Bereichs mit dem vorgegebenen Schalterbereich, - Ermitteln des Zustands des vorgegebenen Schalterbereichs, - Freigeben einer Bewegung der Betätigungsfläche in Antwort auf die Betätigung, wenn der ermittelte Bereich mit dem vorgegebenen Schalterbereich korreliert und wenn dem ermittelten Zustand der aktive Zustand des Schalterbereichs zugeordnet ist, und - Sperren der Bewegung der Betätigungsfläche in Antwort auf die Betätigung, wenn der ermittelte Bereich nicht mit dem vorgegebenen Schalterbereich korreliert und/oder wenn dem ermittelten Zustand der passive Zustand des Schalterbereichs zugeordnet ist.

Aus der Druckschrift DE 10 2014 019 041 B3 ist zudem eine Bedienvorrichtung für ein Fahrzeug, insbesondere einen Kraftwagen, als bekannt zu entnehmen. Die Erfindung betrifft eine Bedienvorrichtung für ein Fahrzeug, insbesondere einen Kraftwagen, mit wenigstens einem Trägerelement, mit wenigstens einem Bedienelement, mittels welchem von einer Person durch Betätigen des Bedienelements wenigstens eine Funktion des Fahrzeugs bewirkbar ist, und mit wenigstens einem Aktor, mittels welchem zur Erzeugung einer haptischen Rückmeldung an die Person infolge der Betätigung des Bedienelements dieses in wenigstens eine Bewegungsrichtung relativ zu dem Trägerelement bewegbar ist, wobei wenigstens ein Fixierelement vorgesehen ist, welches zwischen wenigstens einer das Bedienelement formschlüssig gegen eine Bewegung entlang der Bewegungsrichtung relativ zum Trägerelement sichernden Fixierstellung und wenigstens einer das Bedienelement freigebenden Freigabestellung bewegbar ist.

Darüber hinaus sind in den Druckschriften EP 0 419 145 A1, DE 102007 022 085 A1 und WO 2008 / 151 863 A1 Bedienelemente für Kraftfahrzeuge beschrieben die jeweils ein Gehäuseelement, ein Tastenkappenelement und mindestens ein Hebelelement umfassen. Allgemein kann es gewünscht sein, dass bei passiven Haptik-Systemen, die wie ein normaler Taster funktionieren und immer drückbar sind und zusätzlich noch ein akustisches Feedback geben, eine Tasterfunktionalität nicht immer erwünscht ist. Wenn zum Beispiel ein Display zur Anzeige verbaut wurde, wobei in einigen Regionen des Displays keine Button oder andere Steuermöglichkeiten bereitgestellt werden, ist es mit unter gewünscht, dass das Display bei Druck auf die Front nicht auslöst und kein haptisches sowie akustisches Feedback ausgibt und somit eine erfolgreiche Eingabe quittiert. Auch ist es allgemein gewünscht, dass solche Bedienelemente trotz einer zusätzlichen Funktionalität eine kompakte und einfache Konstruktionsweise aufweisen.

DE 10 2008 046 102 A1 offenbart ein Bedienelement, das zumindest ein Betätigungselement zum Betätigen des Bedienelements umfasst. Ferner ist dem Bedienelement zumindest ein mit dem Betätigungselement wirkverbundene Sensorelement zugeordnet.

EP 3 332 482 A1 offenbart ein Bedienelement für ein Kraftfahrzeug, das ein Gehäuseelement und Tastkappenelement, welches an dem Gehäuseelement angeordnet ist, umfasst.

Der Erfindung liegt nun die Aufgabe zugrunde, ein Bedienelement für ein Kraftfahrzeug bereitzustellen, welches flexibel einsetzbar und eine kompakte Konstruktionsweise aufweist.

In bevorzugter Ausgestaltung der Erfindung ist vorgesehen, dass ein Bedienelement für ein Kraftfahrzeug bereitgestellt wird. Solch ein Bedienelement umfasst dabei ein Gehäuseelement, ein Tastenkappenelement, welches an dem Gehäuseelement angeordnet ist, wenigstens zwei in dem Gehäuseelement angeordnete Hebelelemente und zumindest ein Schaltelement, welches schaltbar zwischen den wenigstens zwei Hebelelementen und dem Tastenkappenelement angeordnet ist. Zudem umfasst das Bedienelement zumindest ein zumindest teilweise elektrisch schaltbares erstes Funktionselement und zumindest ein zweites Funktionselement, welches an den zwei Hebelelementen angeordnet ist. Das zumindest eine zumindest teilweise elektrisch schaltbare erste Funktionselement ist dabei mit dem zumindest einen zweiten Funktionselement wirkverbunden. Eine Zustandsänderung in dem zumindest einem ersten Funktionselement bewirkt dabei eine Zustandsänderung in dem zumindest einen zweiten Funktionselement, sodass mittels wenigstens einem der zwei Hebelelemente bei einer äußeren Krafteinwirkung auf das Tastenkappenelement das zumindest eine Schaltelement von einer ersten Position in eine zweite Position benutzerdefiniert schaltbar ist. Auf diese Weise kann das vorgestellte Bedienelement aufgrund der Interaktion der zwei verschiedenen Funktionselemente flexibel eingesetzt werden. Beispielsweise kann somit auf einfache Weise ein blockierter Zustand des Bedienelements auf einfache Weise erreicht werden. Je nach Zustand des ersten Funktionselements kann somit das zweite Funktionselement beeinflusst werden, sodass ein mechanischer Auslösemechanismus über eine Krafteinwirkung von Außen auf das Tastenkappenelement und somit auf die Hebelelemente gehemmt oder sogar blockiert werden kann. Eine kompakte Bauweise ist dennoch gewährleistet, da an den Hebelelementen keine weiteren mechanischen Komponenten vorgesehen sein müssen, um eine flexible Anwendung zu erreichen. Es ist vielmehr mit einer Anordnung der einzelnen Komponenten des Bedienelements zueinander möglich, verschiedene flexible und einfach zu bedienende Zustände zu erreichen, ohne dass ein höherer konstruktiver Aufwand und damit verbundene Kosten nötig sind. Die Verbindung zwischen den zwei Funktionselementen kann dabei auf Magnetismus beruhen, wobei das erste Funktionselement eine schaltbare Funktionalität aufweist, sodass eine Zustandsänderung bewirkt werden kann, um somit das zweite Funktionselement entsprechend zu beeinflussen.

In weiterer bevorzugter Ausgestaltung der Erfindung ist vorgesehen, dass ein Fahrzeug mit zumindest einem Bedienelement nach den Ansprüchen 1 bis 9 bereitgestellt wird. Die zuvor genannten Vorteile gelten soweit übertragbar auch für das vorgestellte Fahrzeug. Das Fahrzeug kann beispielsweise ein Kraftfahrzeug oder ein jegliches andere Fahrzeug sein.

Weitere bevorzugte Ausgestaltungen der Erfindung ergeben sich aus den übrigen, in den Unteransprüchen genannten Merkmalen.

So ist in einer bevorzugten Ausgestaltung der Erfindung vorgesehen, dass die zwei Hebelelemente wirkverbunden sind, sodass eine jeweilige Bewegung von einem Hebelelement eine jeweilige Bewegung des anderen Hebelelements bewirkt, wobei ein synchroner Bewegungsablauf der zwei Hebelelemente erreichbar ist. Eine kompakte Bauweise ist somit noch besser möglich, da eine zusätzliche Mechanik für eine komfortable Bedienung des Bedienelements entfällt. Durch die jeweilige Übertragung von Bewegungsimpulsen auf das jeweilige andere Hebelelement ist eine gewünschte Ausführung in einer gleichmäßigen Art und Weise möglich. Beispielsweise kann somit eine über die im Wesentlichen gesamte Fläche des Tastenkappenelements, welches zum Beispiel ein Display mit Anzeigefunktion sein kann, gleichmäßig erreicht werden, da eine Auswirkung von einem Hebelelement entsprechend synchron auf das andere Hebelelement übertragen wird, sodass somit eine gleichmäßige Belastung des Displays erreicht wird. Je nach Anzahl und Ausprägung der Hebelelemente lässt sich zudem eine hohe Flexibilität erreichen.

Auch ist in einer bevorzugten Ausgestaltung der Erfindung vorgesehen, dass das zumindest teilweise elektrisch schaltbare erste Funktionselement ein Permanent-Elektromagnet ist. Dabei kann der Anteil mit dem Permanentmagneten eine Blockierfunktion ausüben, welche dann entsprechend mit dem Elektromagnet benutzerdefiniert aufgehoben werden kann. Je nachdem in welchem Zustand der Anteil mit dem Elektromagneten benutzerdefiniert geschaltet wird, kann zudem eine flexible Anwendung des Bedienelements bereitgestellt werden. So kann beispielsweise eine nötige Bedienkraft eines Schaltvorgangs des Bedienelements nivelliert werden, sodass mit einem geringen Bauraum eine hohe Flexibilität erreicht werden kann. Mit anderen Worten hält der Permanentmagnet, der im Elektromagnet verbaut ist, im stromlosen Zustand die Mechanik fest und kann bei Bedarf, beispielsweise wenn ein Finger über das Display gleitet und den Touch in einem Bereich X-Y die Eingabe freigibt mit dem Elektromagneten deaktiviert werden. Das hat den Vorteil, dass der Elektromagnet nur bei Eingabe kurz zugeschaltet wird und den Permanentmagneten neutralisiert und den Rest der Zeit blockiert der Permanentmagnet die Eingabe. Auch bei einem Einsatz in einem stromlosen Fahrzeug wäre das Blockieren des Tasters durch den Permanentmagneten gewährleistet. Anders als bei mechanischen Elementen, wie beispielsweise Schiebern oder Klinken oder rotierenden Blockierelementen, die bei Fehlfunktion des Antriebs in einer Position stehen bleiben können, führt bei einem Elektromagneten eine Fehlfunktion nicht automatisch zur Fehlfunktion des Gesamtsystems. Wenn also andere Taster beziehungsweise die Mechanik von anderen Bedienelementen blockiert werden, sind meist weitere Hebel im Spiel, welche die Bewegungsmöglichkeiten des Tasters einschränken oder komplett eliminieren. Diese zusätzliche Mechanik ist meist mit einem höheren konstruktiven Aufwand und somit höheren Kosten verbunden und die größere Komplexität ist fehleranfälliger. Zudem wird die Schaltfrequenz negativ beeinflusst, da diese bei zusätzlichen Stellgliedern abnimmt. Bei der vorgestellten Lösung mit dem Permanent-Elektromagnet wird keine weitere aufwendige und mitunter mehrteilige Mechanik hinzugefügt, sodass ein geringer Bauraum eingehalten werden kann. Der Elektromagnet neutralisiert den Permanentmagneten beispielsweise in dem Moment, wenn die Touch-Elektronik auf der Tastenoberfläche den Befehl dazu gibt. Dies kann beispielsweise in Sekundenbruchteilen vollzogen werden.

Ferner ist in einer bevorzugten Ausgestaltung der Erfindung vorgesehen, dass das zumindest teilweise elektrisch schaltbare erste Funktionselement ein Elektromagnet ist. In dieser Ausführungsvariante kann eine gewünschte Schaltweise direkt ausschließlich über den Elektromagneten gewährleistet werden, sodass mit einem geringen Bauraum eine hohe Flexibilität erreicht werden kann.

Zudem ist in einer bevorzugten Ausgestaltung der Erfindung vorgesehen, dass das zumindest teilweise elektrisch schaltbare erste Funktionselement ein bistabiler Elektromagnet ist. In dieser Ausführungsvariante kann eine gewünschte Schaltweise noch besser direkt ausschließlich über den bistabilen Elektromagneten gewährleistet werden, sodass mit einem geringen Bauraum eine hohe Flexibilität erreicht werden kann.

Auch ist in einer bevorzugten Ausgestaltung der Erfindung vorgesehen, dass das zumindest eine zweite Funktionselement ein Permanentmagnet ist. Auf diese Weise kann eine besonders flexible Interaktion zwischen den Funktionselementen bereitgestellt werden, wobei lediglich ein geringer Bauraum für die Anordnung vorgehalten werden muss. Je nach Ausprägung und Größe des Permanentmagnets kann zudem eine hohe Flexibilität bezogen auf die Betriebsweise des Bedienelements bereitgestellt werden.

Ferner ist in einer bevorzugten Ausgestaltung der Erfindung vorgesehen, dass das zumindest eine zweite Funktionselement zumindest teilweise aus einer Metalllegierung, insbesondere einer Metalllegierung zumindest Eisen umfassend, aufgebaut ist. Auf diese Weise kann eine besonders zuverlässige Interaktion zwischen den Funktionselementen bereitgestellt werden, wobei lediglich ein geringer Bauraum für die Anordnung vorgehalten werden muss. Je nach Ausprägung und Größe des Permanentmagnets kann zudem eine hohe Flexibilität bezogen auf die Betriebsweise des Bedienelements bereitgestellt werden.

Zudem ist in einer bevorzugten Ausgestaltung der Erfindung vorgesehen, dass das zumindest eine zweite Funktionselement in den jeweiligen Hebelelementen mittels eines jeweiligen Aufhängeelementes angeordnet ist und zumindest teilweise in das jeweilige erste Funktionselement hineinragt. Mittels der jeweiligen Aufhängeelemente kann sicher gestellt werden, dass eine Positionierung des entsprechenden zweiten Funktionselements zuverlässig vollzogen werden kann, sodass eine hohe Flexibilität erreichbar ist. Aufgrund des Ineinandergreifens der Elemente lässt sich zudem noch besser eine kompakte Bauweise bereitstellen.

Schlussendlich ist in einer bevorzugten Ausgestaltung der Erfindung vorgesehen, dass das zumindest eine zweite Funktionselement zumindest teilweise aus einer Metalllegierung, insbesondere einer Metalllegierung zumindest Eisen umfassend, aufgebaut ist und mittels eines Drehachsenelements mit den zwei Hebelelementen wirkverbunden ist, sodass ein Bewegungsimpuls von zumindest einem der zwei Hebelelemente das zumindest eine zweite Funktionselement derart bewegt, sodass bei einer äußeren Krafteinwirkung auf das Tastenkappenelement das zumindest eine Schaltelement von einer ersten Position in eine zweite Position mittels wenigstens einem der Hebelelemente und des zweiten Funktionselements benutzerdefiniert schaltbar ist. Die zuvor genannten Vorteile sind somit noch besser erreichbar.

Die verschiedenen in dieser Anmeldung genannten Ausführungsformen der Erfindung sind, sofern im Einzelfall nicht anders ausgeführt, mit Vorteil miteinander kombinierbar.

Die Erfindung wird nachfolgend in Ausführungsbeispielen anhand der zugehörigen Zeichnungen erläutert. Es zeigen:
- Figur 1: eine perspektivische Schnittansicht eines Bedienelements in einer ersten Variante;
- Figur 2: eine Draufsicht auf eine Schnittsicht eines Bedienelement in einer ersten Variante;
- Figur 3: eine schematische Schnittansicht eines Bedienelements in einer ersten Variante;
- Figur 4: eine schematische Schnittansicht eines Bedienelements in einer ersten Variante in einem ersten Zustand;
- Figur 5: eine schematische Schnittansicht eines Bedienelements in einer ersten Variante in einem zweiten Zustand;
- Figur 6: eine schematische Schnittansicht eines Bedienelements in einer zweiten Variante;
- Figur 7: eine schematische Schnittansicht eines Bedienelements in einer dritten Variante;
- Figur 8: eine schematische Schnittansicht eines Bedienelements in einer vierten Variante;
- Figur 9: eine schematische Schnittansicht eines Bedienelements in einer fünften Variante;
- Figur 10: eine schematische Schnittansicht eines Bedienelements in einer sechsten Variante;
- Figur 11: eine weitere schematische Schnittansicht eines Bedienelements in einer sechsten Variante;
- Figur 12: eine schematische Schnittansicht eines Bedienelements in einer siebten Variante;
- Figur 13: eine weitere schematische Schnittansicht eines Bedienelements in einer siebten Variante;
- Figur 14: eine weitere schematische Schnittansicht eines Bedienelements in einer siebten Variante;
- Figur 15: ein Fahrzeug mit einem Bedienelement.

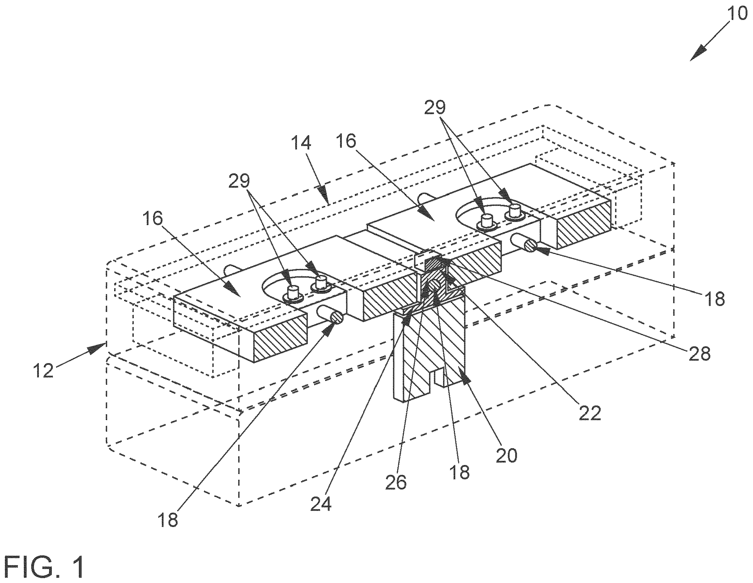

Figur 1 zeigt eine perspektivische Schnittansicht eines Bedienelements 10 in einer ersten Variante. Nach außen wird das Bedienelement 10 durch ein Gehäuseelement 12 begrenzt, wobei auf der Oberseite (bezogen auf die Bildebene) ein Tastenkappenelement 14 in das Gehäuseelement 12 angeordnet beziehungsweise eingelassen ist. In dem Gehäuseelement 12 sind zudem zwei Hebelelemente 16 dargestellt. Die Hebelelemente 16 sind jeweils durch ein Drehachsenelement 18 gelagert, sodass sich die Hebelelemente 16, wenn eine Krafteinwirkung auf das Tastenkappenelement 14 und somit auch auf die Hebelelemente 18 einwirkt, bewegen lassen. Unterhalb der zwei Hebelelementen 16 und im Wesentlichen mittig angeordnet ist ein erstes Funktionselement 20 dargestellt, welches in dieser Variante beispielsweise ein Permanent-Elektromagnet ist. Zwischen den Hebelelementen 16 ist ein zweites Funktionselement 22 dargestellt, wobei dieses zweite Funktionselement 22 mit einem breiten Sockelbereich 24 im Wesentlichen bündig über einem oberen Bereich des ersten Funktionselements 20 angeordnet ist. Der sich an den Sockelbereich 24 anschließende Hauptkörper 26 ist schmäler als der Sockelbereich 24 und weist ein weiteres Drehachsenelement 18 auf, welches mit den zwei Hebelelementen 16 wirkverbunden ist. Mit anderen Worten kann somit eine Bewegung der zwei Hebelelemente 16 auf dieses zweite Funktionselement 22 übertragen werden. Das obere Ende dieses zweiten Funktionselements 22 ist unterhalb eines Schaltelements 28 positioniert, sodass bei einer Bewegung des zweiten Funktionselements 22 nach oben (bezogen auf die Bildebene) das Schaltelement 28 nach oben gedrückt wird und somit schaltet, indem es von seiner ersten Position in eine zweite Position überführt wird. Das erste Funktionselement 20 hält beispielsweise mittels des Permanentmagneten das zweite Funktionselement 22 in einer ersten Position, sodass sich auch das Schaltelement 28 in einer ersten Position befindet. Mittels des eingeschalteten Elektromagnets des ersten Funktionselements 20 kann dann der Permanentmagneten übersteuert werden, sodass, wenn die zwei Hebelelemente 16 bewegt werden beziehungsweise wenn wenigstens einer davon bewegt wird, dieser übertragene Bewegungsimpuls eine Bewegung des zweiten Funktionselements 22 ermöglicht. Als Folge befindet sich dann das zweite Funktionselement 22 in einer zweiten Position, sodass sich auch das Schaltelement 28 in einer zweiten Position befindet und somit ein Schaltvorgang des Schaltelements 28 erfolgt. Beispielsweise können die Abmaße eines solchen Bedienelements 10 wie folgt sein: Länge = 140 mm, Breite = 80 mm, Höhe = 49 mm. Jegliche andere Abmaße sind ebenfalls in nicht gezeigten Untervarianten vorstellbar. Das Bedienelement 10 und seine Komponenten kann dabei zumindest teilweise mittels eines 3D-Druckverfahrens erstellt werden. Es kann dabei zumindest teilweise transparentes Material eingesetzt werden. Zudem können Bestandteile zumindest teilweise Eisen ST 37 enthalten. Auch können Carbonfasermaterialien eingesetzt werden. Beispielsweise kann ein Carbonfaserstab mit einem Durchmesser von 2 mm eingesetzt werden. Auch kann eine nicht näher dargestellte Ankeraufhängung an den zwei Hebeln vorgesehen sein. Um die einzelnen Bestandteile zusammen halten, können beispielsweise M3 Schrauben verwendet werden. An den Hebelelementen 16 sind zudem in dieser Darstellung jeweils zwei Switchs 29 dargestellt, wobei diese jeweils auf einer gesonderten Abschnitt des jeweiligen Hebelelements 16 angeordnet sind. Mittels dieser Switchs 29, welche auch als Tasterelement bezeichnet werden können, kann eine gezieltere Einwirkung auf die jeweiligen Hebelelemente 16 und somit auf die dem Bedienelement zugrundeliegenden Mechanik beziehungsweise Funktionsweise ermöglicht werden.

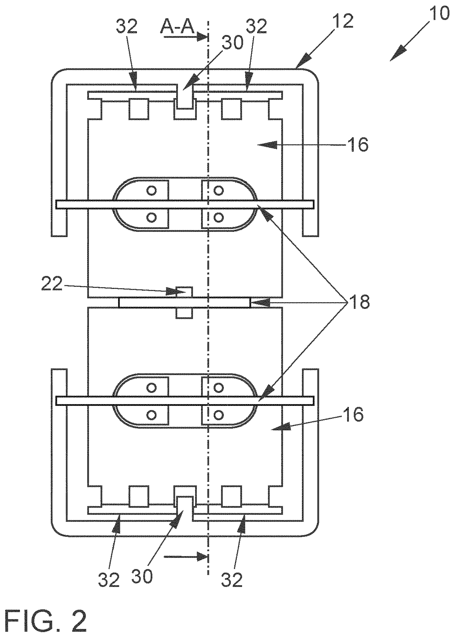

Figur 2 zeigt eine Draufsicht auf eine Schnittsicht eines Bedienelement 10 in einer ersten Variante. Nach außen wird das Bedienelement 10 durch ein Gehäuseelement 12 begrenzt. In dem Gehäuseelement 12 sind zudem zwei Hebelelemente 16 dargestellt. Die Hebelelemente 16 sind jeweils durch ein Drehachsenelement 18 gelagert. Zwischen den zwei Hebelelementen 16 ist angeschnitten ein zweites Funktionselement 22 im Sinne der Figur 1 zu erkennen, wobei ein weiteres Drehachsenelement 18 durch dieses zweite Funktionselement 22 ragt und mit den zwei Hebelelementen 16 wirkverbunden ist. Zudem ist eine Schnittachse A-A dargestellt, welche als ein Verweis auf die Schnittansichten der folgenden Figuren vorgesehen ist. Die zwei Hebelelemente 16 sind mit jeweiligen Haltevorrichtungen 30 über jeweils zwei Halteelemente 32 in dem Gehäuseelement 12 angeordnet, wobei auch die jeweiligen Drehachsenelemente 18 an einem Innenbereich des Gehäuseelementes 12 angeordnet sind. Zwischen den Hebelelementen 16, welche auch nur als Hebel bezeichnet werden können, und dem zweiten Funktionselement 22, welches auch als Anker mit Ankerachse bezeichnet werden kann, kann beispielsweise ein Spiel von 0,05 mm vorgesehen sein. Zwischen jeweiligen Drehachsenelementen 18 und Hebelelementen 16 kann beispielsweise ein Spiel von 0,03 mm vorgesehen sein. Bei den Haltevorrichtungen 30 mit den jeweiligen Halteelementen 32 kann beispielsweise ein Spiel von 0,1 mm vorgesehen sein. Die jeweiligen Drehachsenelemente 18 können zum Beispiel über nicht näher dargestellte Lagerblöcke in dem Gehäuseelement 12 vorgesehen sein.

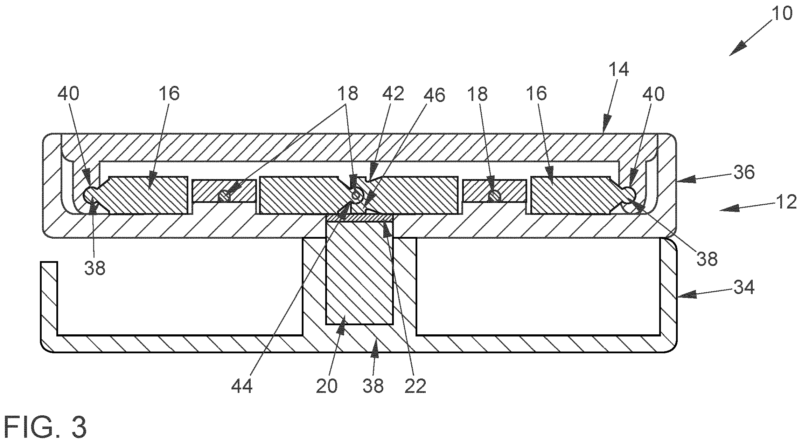

Figur 3 zeigt eine schematische Schnittansicht eines Bedienelements 10 in einer ersten Variante. Diese Schnittansicht bezieht sich dabei auf die Schnittachse A-A aus Figur 2 und auf den dort dargestellten Gegenstand. Es ist das Gehäuseelement 12 dargestellt, wobei in dieser Darstellung zwei separate Halterahmenelemente 34, 36 dargestellt sind. Das untere Halterahmenelement 34 weist dabei eine im Wesentlichen mittig angeordnete Positionierungseinrichtung 38 auf, in welcher das erste Funktionselement 20 positioniert ist. In dieser ersten Variante kann das erste Funktionselement 20 wie bereits gesagt ein Permanent-Elektromagnet sein. Dieses positionierte erste Funktionselement 20 in Form eines Permanent-Elektromagneten ragt dabei aus der Positionierungseinrichtung 38 nach oben hervor und ragt dabei in das zweite Halterahmenelement 36 hinein. Oberhalb dieses ersten Funktionselements 20 ist im Sinne der vorherigen Figuren das zweite Funktionselement 22 dargestellt. In dem zweiten Halterahmenelement 36 sind neben dem zweiten Funktionselement 22 auch die zwei Hebelelemente 16 angeordnet, wobei in dieser Schnittansicht auch die jeweiligen Drehachsenelemente 18 dargestellt sind. In dieser Schnittansicht wird zudem verdeutlicht, dass die zuvor bereits erwähnten Halteelemente 32 zu dem darüber gezeigten Tastenkappenelement 14 gehören. Mit anderen Worten sind die Hebelelemente 16 jeweils im Seitenbereich (bezogen auf die Bildebene) an diesen Halteelementen 32 angeordnet, wobei Vorsprünge 38 von den jeweiligen Hebelelemente 16 in entsprechenden Nutelementen 40 der Halteelemente 32 angeordnet sind. Das Tastenkappenelement 14 ist seitlich jeweils in dem Halterahmenelement 36 eingelassen und erstreckt sich von links nach rechts über die zwei Hebelelemente 16. Die zwei Hebelelemente 16 stehen in einem Verbindungsbereich 42 miteinander in Kontakt. In diesem Verbindungsbereich 42 ist auch das für die Hebelelemente 16 gemeinsam vorgesehene Drehachsenelement 18 vorgesehen. Im Verbindungsbereich 42 trifft eine Vorsprungelement 44 von dem linken Hebelelement 16 auf ein Aufnahmeelement 46 von dem rechten Hebelelement 16. Eine jeweilige Bewegung der Hebelelemente 16 ist somit auf das jeweils andere Hebelelement 16 übertragbar. Die Hebelelemente 16 können beispielsweise + - 0,5° um den Drehpunkt gedreht werden. Das Tastenkappenelement 14 kann beispielsweise nur noch + - 0,28 mm in Z bewegt werden. Zwischen dem Tastenkappenelement 14 und den Hebelelementen 16 kann in dem seitlichen Aufhängebereich ein Spiel von 0,05 mm vorgesehen sein.

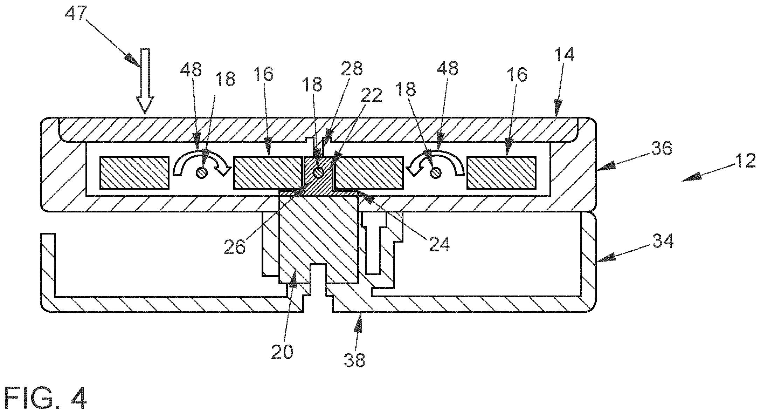

Figur 4 zeigt eine schematische Schnittansicht eines Bedienelements 10 in einer ersten Variante in einem ersten Zustand. Die gezeigten Komponenten beziehen sich auf die in den zuvor erläuterten Figuren und werden deswegen nicht gesondert nochmals erläutert. Wenngleich die Bezugszeichen in der Figur 4 selbst für den Zweck der besseren Interpretation vorgesehen sind. Ein Kraftrichtungsfpeil 47 deutet die Richtung an, in welcher das Tastenkappenelement 14 und somit das darunterliegende Hebelelement 16 belastet werden kann. In diesem ersten Zustand hält allerdings der Permanentmagnet das zweite Funktionselement 22, welches auch als Anker bezeichnet werden kann, fest, sodass eine Krafteinwirkung in Richtung des gezeigten Kraftrichtungsfpeil 47 keine Veränderung der ersten Position des zweiten Funktionselements 22 bewirkt. Jeweilige Bewegungspfeile 48 an den Hebelelementen 16 verdeutlichen diesen ersten Zustand. Dabei sind die Hebelelemente 16 beispielsweise - 0,5° gedreht. Das Tastenkappenelement 14 kann beispielsweise 0,28 mm über dem Gehäuseelement 12 stehen. Zudem ist in der Figur 4 das Schaltelement 28 dargestellt. Dies Schaltelement 28 kann zudem ein nicht näher dargestellten Silikonplunger umfassen, welcher das Schaltelement 28 stabil in Position hält. In diesem Zustand ist das Schaltelement 28 in einer nicht näher verdeutlichten ersten Position und ist also nicht geschaltet.

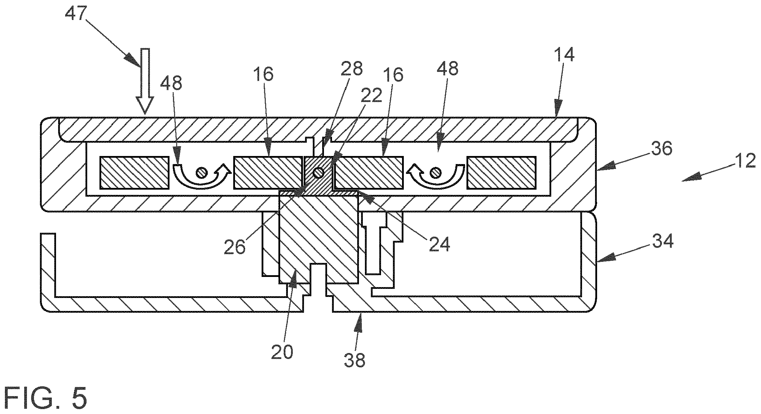

Figur 5 zeigt eine schematische Schnittansicht eines Bedienelements 10 in einer ersten Variante in einem zweiten Zustand. Die gezeigten Komponenten beziehen sich auf die in den zuvor erläuterten Figuren und werden deswegen nicht gesondert nochmals erläutert. Wenngleich die Bezugszeichen in der Figur 5 selbst für den Zweck der besseren Interpretation vorgesehen sind. Ein Kraftrichtungsfpeil 47 deutet die Richtung an, in welcher das Tastenkappenelement 14 und somit das darunterliegende Hebelelement 16 belastet werden kann. In diesem zweiten Zustand kann allerdings der Permanentmagnet das zweite Funktionselement 22, welches auch als Anker bezeichnet werden kann, nicht mehr fest halten, da der darunterliegende Elektromagnet von dem ersten Funktionselement 20 nunmehr eingeschaltet ist und somit ausreichend entgegen der Kraft des Permanentmagneten des ersten Funktionselements 20 wirkt. Eine Krafteinwirkung in Richtung des gezeigten Kraftrichtungsfpeil 47 kann nunmehr eine Veränderung der ersten Position des zweiten Funktionselements 22 bewirken, sodass das zweite Funktionselement 22 frei ist, um von den zwei Hebelelementen 16 oder wenigstens einem der zwei Hebelelemente 16 bewegt zu werden. Jeweilige Bewegungspfeile 48 an den Hebelelementen 16 verdeutlichen diesen zweiten Zustand, wobei nun das zweite Funktionselement 22 entsprechend das darüber angeordnete Schaltelement 28 von einer ersten Position in eine zweite Position bewegen kann, sodass sich dort ein Schaltvorgang vollziehen lässt. Dabei sind die Hebelelemente 16 beispielsweise + 0,5° gedreht. Das Tastenkappenelement 14 kann beispielsweise 0,28 mm über dem Gehäuseelement 12 stehen. Zudem ist in der Figur 5 das Schaltelement 28 dargestellt. Dies Schaltelement 28 kann zudem ein nicht näher dargestellten Silikonplunger umfassen, welcher das Schaltelement 28 stabil in Position hält. In diesem Zustand ist das Schaltelement 28 in einer nicht näher verdeutlichten zweiten Position und ist also in einem geschalteten Zustand. Der Permanent-Elektromagnet greift möglichst in der Mitte an den sich zugewandten Hebeln an, da hier mit den kleinsten Kräften des Permanentmagnets die größte Auslösekraft auf der Tastenoberfläche erzielt werden kann. In einem Versuchsbau konnte beispielsweise nachvollzogen werden, dass Haltekräfte des Permanentmagneten von 40 N erreicht werden können. Erst mit einer Belastung von 43 N auf der Tastenoberfläche konnten die Haltekräfte des Permanentmagneten überwunden werden. Diese starken Kräfte kommen einer unsachgemäßen Handhabung gleich, sodass davon auszugehen ist, dass in einem normalen Anwendungsfalls die Konstruktion auf vorgesehene Art und Weise funktioniert. Mit anderen Worten kann ein Nutzer klar unterscheiden, ob die Eingabe mit ungefähr 3 N oder mit 43 N vollzogen wird. Über die Hebellängen der Hebel beziehungsweise die Variation dieser Länge könnte die Blockierkraft noch erhöht beziehungsweise allgemein eingestellt werden. Auch könnte die Größe des Permanentmagneten eingestellt werden, um eine entsprechende Einstellung zu erreichen. Es lässt sich also eine Abhebekraft des Ankers vom Magneten somit fein steuern. Dabei wird die Kraft des Permanentmagneten nicht vollständig ausgelöscht, sondern nur bis zu einem bestimmten Wert. Mit dieser Methode kann man auf der Tastenkappe unterschiedliche Tasten darstellen, die auch unterschiedliche Auslösekräfte aufweisen können.

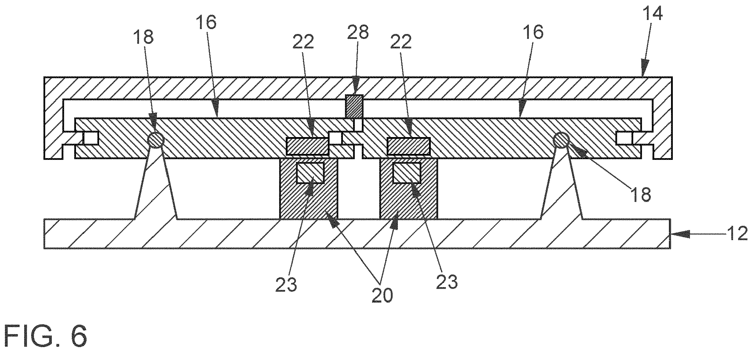

Figur 6 zeigt eine schematische Schnittansicht eines Bedienelements 10 in einer zweiten Variante. Die gezeigten Komponenten beziehen sich auf die in den zuvor erläuterten Figuren und werden deswegen nicht gesondert nochmals erläutert. Wenngleich die Bezugszeichen in der Figur 6 selbst für den Zweck der besseren Interpretation vorgesehen sind. Es sind dabei nur für die Erläuterung dieser zweiten Variante entscheidende Komponenten dargestellt. Es sind in dieser zweiten Variante zwei erste Funktionselemente 20 dargestellt, welche ebenfalls als Permanent-Elektromagnet vorgesehen sind, wobei ein jeweiliger Permanentmagnet 23 in dieser Figur 6 explizit dargestellt ist. Die gezeigten zweiten Funktionselemente 22 sind diesmal in Form von Eisen-Ankern direkt in den jeweiligen Hebelelementen 16 vorgesehen, sodass eine besonders kompakte Bauweise realisiert ist. Die gezeigten Drehachsenelemente 18 weisen in dieser Darstellung eine direkte Verbindung mit dem Gehäuseelement 12 auf. Da die Hebel sich bei dieser Variante mittels der neuen Mechanik zwischen den Hebelelementen 16, also dem ineinandergreifen der Hebelelemente 16, gegenseitig über eine Evolvente antreiben lassen, entfällt die Notwendigkeit einer Aufhängung für den Anker beziehungsweise das zweite Funktionselement 22. Mit Hilfe des Permanent-Elektromagnet lässt sich die Abhebekraft des Ankers vom Magneten fein steuern. Dabei wird die Kraft des Permanentmagneten nicht vollständig ausgelöscht, sondern nur bis zu einem bestimmten Wert. Mit dieser Art und Weise beziehungsweise Methode kann man auf der Tastenkappe beziehungsweise über das Tastenkappenelement 14 unterschiedliche Tasten darstellen, die dann auch unterschiedliche Auslösekräfte aufweisen.

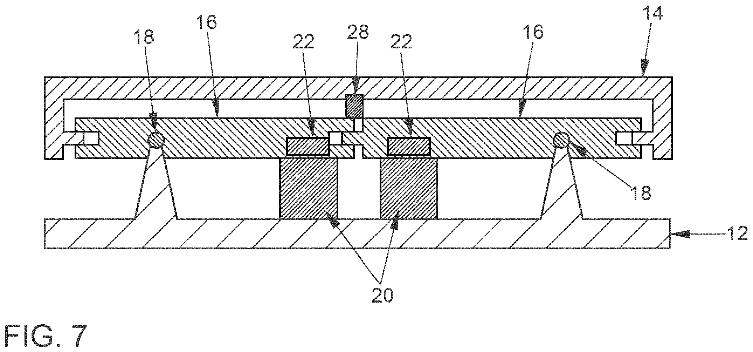

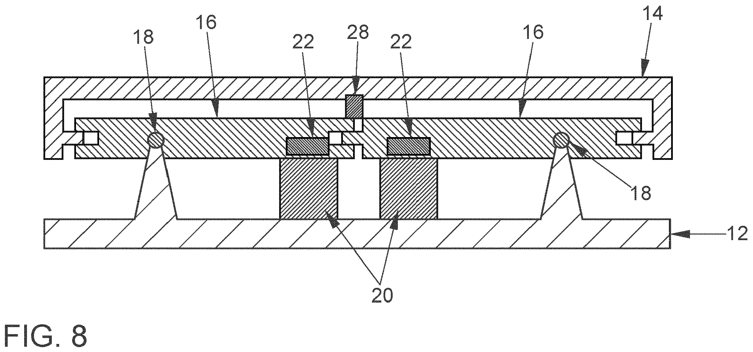

Figur 7 zeigt eine schematische Schnittansicht eines Bedienelements 10 in einer dritten Variante. Die gezeigten Komponenten beziehen sich auf die in den zuvor erläuterten Figuren und werden deswegen nicht gesondert nochmals erläutert. Wenngleich die Bezugszeichen in der Figur 7 selbst für den Zweck der besseren Interpretation vorgesehen sind. Es sind dabei nur für die Erläuterung dieser dritten Variante entscheidende Komponenten dargestellt. Es sind in dieser dritten Variante zwei erste Funktionselemente 20 dargestellt, welche diesmal als Elektromagnet vorgesehen sind. Die gezeigten zweiten Funktionselemente 22 sind diesmal in Form von Permanentmagneten direkt in den jeweiligen Hebelelementen 16 vorgesehen, sodass eine besonders kompakte Bauweise realisiert ist. Die gezeigten Drehachsenelemente 18 weisen in dieser Darstellung eine direkte Verbindung mit dem Gehäuseelement 12 auf. Figur 8 zeigt eine schematische Schnittansicht eines Bedienelements 10 in einer vierten Variante. Die gezeigten Komponenten beziehen sich auf die in den zuvor erläuterten Figuren und werden deswegen nicht gesondert nochmals erläutert. Wenngleich die Bezugszeichen in der Figur 8 selbst für den Zweck der besseren Interpretation vorgesehen sind. Es sind dabei nur für die Erläuterung dieser vierten Variante entscheidende Komponenten dargestellt. Es sind in dieser vierten Variante zwei erste Funktionselemente 20 dargestellt, welche diesmal als bistabiler Elektromagnet vorgesehen sind. Die gezeigten zweiten Funktionselemente 22 sind diesmal in Form von Eisen-Anker direkt in den jeweiligen Hebelelementen 16 vorgesehen, sodass eine besonders kompakte Bauweise realisiert ist. Die gezeigten Drehachsenelemente 18 weisen in dieser Darstellung eine direkte Verbindung mit dem Gehäuseelement 12 auf. Der bistabile Elektromagnet ermöglicht eine einstellbare dauerhafte Magnetisierung des Spulenkerns. Somit sind die Abhebekräfte des Eisen-Ankers im Hebel einstellbar. Ein Nutzer könnte beispielsweise über eine Menü (Display und Intelligenz des Systems vorausgesetzt) die für ihn angenehmen Betätigungskräfte einstellen. Auch könnte somit ein jeweiliger verschiedentlicher Einsatzbereich eine andere Programmierung bedingen, sodass das Bedienelement 10 jeweils anders reagiert.

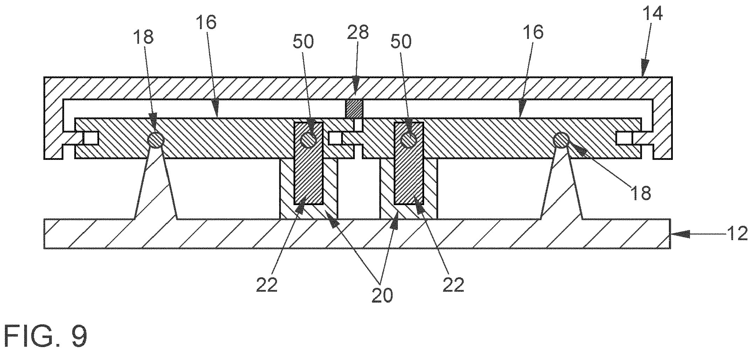

Figur 9 zeigt eine schematische Schnittansicht eines Bedienelements 10 in einer fünften Variante. Die gezeigten Komponenten beziehen sich auf die in den zuvor erläuterten Figuren und werden deswegen nicht gesondert nochmals erläutert. Wenngleich die Bezugszeichen in der Figur 9 selbst für den Zweck der besseren Interpretation vorgesehen sind. Es sind dabei nur für die Erläuterung dieser fünften Variante entscheidende Komponenten dargestellt. Es sind in dieser fünften Variante zwei erste Funktionselemente 20 dargestellt, welche diesmal als Elektromagnet vorgesehen sind. Die gezeigten zweiten Funktionselemente 22 sind diesmal in Form von Eisen-Ankern direkt in den jeweiligen Hebelelementen 16 vorgesehen, sodass eine besonders kompakte Bauweise realisiert ist. Dabei ragen diese Eisen-Anker jeweils in die ersten Funktionselemente 20 rein, wobei ein jeweiliges Aufhängeelement 50 in den Hebelelementen 16 eine kontrollierte Positionierung während des Betriebes sicherstellen. Mit anderen Worten sind die Aufhängeelement 50 in Form von Drehachsen vorgesehen, sodass die aufgehängten zweiten Funktionselemente 22 definiert und im Wesentlichen lotrecht in die Spulen des Elektromagneten eintauchen können und auch bei einer Veränderung der Positionierung der Hebel an sich diese nicht verlassen. Eine kontinuierliche Steuerung der Spulen ist somit möglich. Mit anderen Worten kann der Elektromagnet in Form eines Solenoids vorgesehen sein. Die gezeigten Drehachsenelemente 18 von den Hebelelementen 16 weisen in dieser Darstellung eine direkte Verbindung mit dem Gehäuseelement 12 auf. In den Figuren 6 bis 8 wird gezeigt, inwiefern ein Teil des Blockiermechanismusses in den Hebeln vorgehalten wird und der andere Teil entsprechend auf der Grundplatte von dem Gehäuseelement 12. Je mehr sich dabei die Bauteile durch die Drehbewegung voneinander entfernen, desto mehr reduziert sich der Einfluss des Magnetismusses der jeweiligen Aktorpaare. Mit dem Einsatz des vorgestellten Solenoids würde sich das ändern und es kann eine kontinuierliche Steuerung der Spule ermöglicht werden. Es ist dabei ein spezielles Augenmerk auf die Verbindung Hebel zum Solenoid-Anker zu setzen, da der Hebel bei der Rotation um 0,5° den Verbindungspunkt zum Anker in Y verschiebt, sodass an dieser Stelle ein ausreichendes Spiel einzuplanen ist.

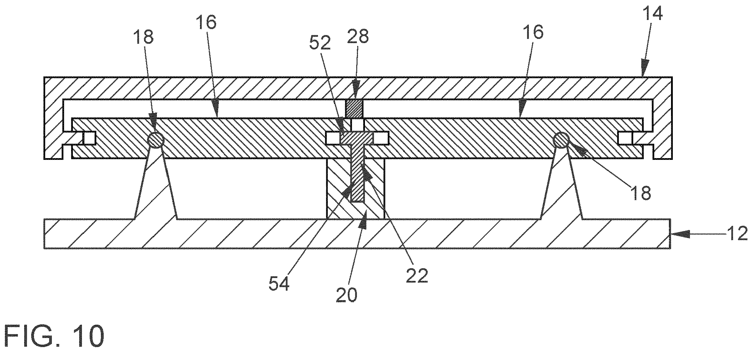

Figur 10 zeigt eine schematische Schnittansicht eines Bedienelements 10 in einer sechsten Variante. Die gezeigten Komponenten beziehen sich auf die in den zuvor erläuterten Figuren und werden deswegen nicht gesondert nochmals erläutert. Wenngleich die Bezugszeichen in der Figur 10 selbst für den Zweck der besseren Interpretation vorgesehen sind. Es sind dabei nur für die Erläuterung dieser sechsten Variante entscheidende Komponenten dargestellt. Es ist in dieser sechsten Variante nur ein erstes Funktionselement 20 dargestellt, welches diesmal als Elektromagnet vorgesehen ist. In einer nicht gezeigten Untervariante diese sechsten Variante könnte das erste Funktionselement 20 auch ein Elektromagnet sein, welcher zudem einen Permanentmagneten beinhaltet oder dieser Elektromagnet könnte als bistabil ausgeführt werden. Das gezeigte zweite Funktionselement 22 ist diesmal in Form eines Eisen-Ankers zwischen den jeweiligen Hebelelementen 16 vorgesehen, sodass eine besonders kompakte Bauweise realisiert ist. Dabei ist das zweite Funktionselement 22 mit einem Zahnprofil dargestellt, wobei ein Kopfbereich 52 breiter als ein Stilbereich 54 ist. Der Kopfbereich 52 ragt dabei links und rechts in jeweilige Hebelelemente 16 hinein und der Stilbereich 54 ragt in das erste Funktionselement 22 hinein. Der Anker ist also so ausgeführt, dass das Zahnprofil (passend zu den Zähnen in den Hebeln) in Kontakt mit den Hebelenden steht, die sich gegenseitig über eine Verzahnung antreiben (vor und hinter dem Solenoid-Anker sind die Hebelenden dabei wieder gegenseitig im Eingriff).

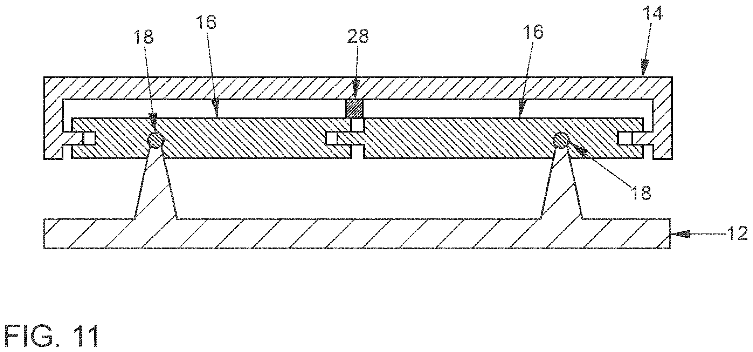

Figur 11 zeigt eine weitere schematische Schnittansicht eines Bedienelements 10 in einer sechsten Variante. Abweichend wird hier ein anderer Schnitt angezeigt, wobei dieser Schnitt vor oder hinter dem Solenoid ist.

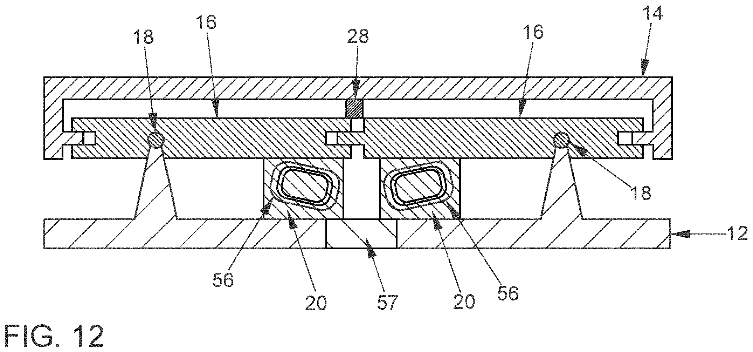

Figur 12 zeigt eine schematische Schnittansicht eines Bedienelements in einer siebten Variante. Die gezeigten Komponenten beziehen sich auf die in den zuvor erläuterten Figuren und werden deswegen nicht gesondert nochmals erläutert. Wenngleich die Bezugszeichen in der Figur 12 selbst für den Zweck der besseren Interpretation vorgesehen sind. Es sind dabei nur für die Erläuterung dieser siebten Variante entscheidende Komponenten dargestellt. Es sind in dieser siebten Variante zwei erste Funktionselemente 20 dargestellt, welche diesmal als Elektromagnet vorgesehen sind, wobei jeweilige Spulenelemente 56 explizit eingezeichnet sind. Zudem ist ein zughöriges Eisenankerelement 57 dargestellt, welches mittig zwischen den zwei ersten Funktionselementen 20 in dem Gehäuseelement 12 angeordnet ist. Die zweiten Funktionselemente 22 sind in dieser siebten Variante Permanentmagneten, welche nicht näher dargestellt sind und zumindest teilweise in den jeweiligen Hebelelementen 16 vorgesehen sind.

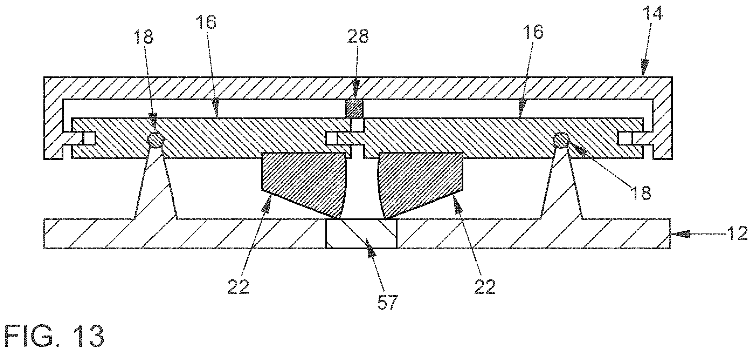

Figur 13 zeigt eine weitere schematische Schnittansicht eines Bedienelements 10 in einer siebten Variante. Die gezeigten Komponenten beziehen sich auf die in den zuvor erläuterten Figuren und werden deswegen nicht gesondert nochmals erläutert. Wenngleich die Bezugszeichen in der Figur 13 selbst für den Zweck der besseren Interpretation vorgesehen sind. Die ersten Funktionselemente 20 sind diesmal nicht dargestellt. Hingegen sind die zweiten Funktionselemente 22, welche in dieser siebten Variante Permanentmagneten sind, dargestellt, wobei sie zumindest teilweise in den jeweiligen Hebelelementen 16 vorgesehen sind. Dieser besondere Schnitt könnte beispielsweise 5 mm vor oder hinter den nicht näher gezeigten Spulenelementen 56 sein. Mit anderen Worten sind die Permanentmagneten fest in den Hebeln verankert. Die Permanentmagneten bilden ein starkes homogenes Magnetfeld aus, in das die Spulenelemente 56 eintauchen. Bei Betätigung des Tastenkappenelements 14 bewegen sich die Hebel und die Magnete um das jeweilige Drehachsenelement 18. Dabei schneiden die Feldlinien der Magnete die Leiter der Spulen im 90° Winkel. Die Permanentmagneten werden zum Eisenankerelement 57 auf die Grundplatte der Gehäuseelements 12 gezogen. Fließt nun Strom durch die Spulen, bauen sich Magnetfelder auf, die dem permanenten Magnetfeld der Magnete in den Hebeln Kräfte entgegenstellen. Dadurch kann der Hebel sehr genau bewegt werden (Analogie zur Festplatte, wo die einzelnen Spuren der zylindrischen Datenbahnen sehr genau gehalten werden können und auch sehr schnell gewechselt werden können). In diesem Fall würde das Tastenkappenelement 14 in Z sehr präzise gesteuert werden können. Bei Freigabe, beispielsweise durch einen Touchcontroller, wird soviel Strom durch die Spule geleitet, dass die Hebel mit den Magneten vom Anker der Grundplatte gelöst werden. Der Druck auf das Tastenkappenelement 14 wird wohl in den Spulen detektierbar sein und kann gesteuert nachgeführt werden, bis der Taster ausgelöst wird. Da hier nur sehr kleine Winkelbewegungen < + - 2° benötigt werden, können zum Beispiel rechteckige Magnete und Spulen benutzt werden.

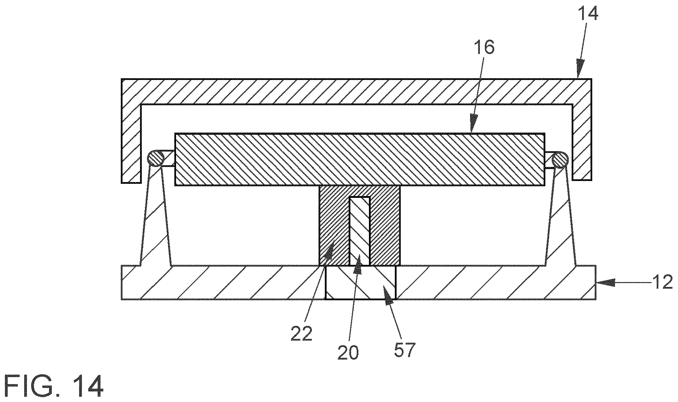

Figur 14 zeigt eine weitere schematische Schnittansicht eines Bedienelements in einer siebten Variante. Die gezeigten Komponenten beziehen sich auf die in den zuvor erläuterten Figuren und werden deswegen nicht gesondert nochmals erläutert. Wenngleich die Bezugszeichen in der Figur 14 selbst für den Zweck der besseren Interpretation vorgesehen sind. Diese Seitenschnittansicht verdeutlicht die jeweiligen Komponenten und deren Zusammenspiel in dieser siebten Variante.

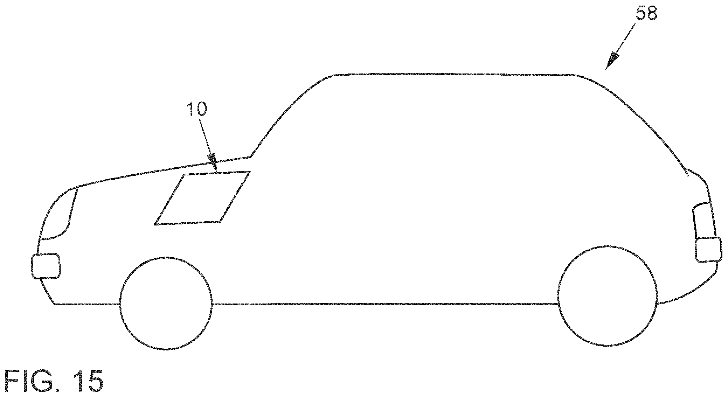

Figur 15 zeigt ein Fahrzeug 58 mit einem Bedienelement 10.

### Bezugszeichenliste

- 10: Bedienelement
- 12: Gehäuseelement
- 14: Tastenkappenelement
- 16: Hebelelement
- 18: Drehachsenelement
- 20: erstes Funktionselement
- 22: zweites Funktionselement
- 24: Sockelbereich
- 26: Hauptkörper
- 28: Schaltelement
- 29: Switch
- 30: Haltevorrichtung
- 32: Halteelement
- 34: unteres Halterahmenelement
- 36: oberes Halterahmenelement
- 38: Vorsprung
- 40: Nutelement
- 42: Verbindungsbereich
- 44: Vorsprungelement
- 46: Aufnahmeelement
- 47: Kraftrichtungspfeil
- 48: Bewegungspfeil
- 50: Aufhängeelement
- 52: Kopfbereich
- 54: Stilbereich
- 56: Spulenelement
- 57: Eisenankerelement
- 58: Fahrzeug

## Patentansprüche

1. Bedienelement (10) für ein Kraftfahrzeug umfassend ein Gehäuseelement (12), ein Tastenkappenelement (14), welches an dem Gehäuseelement (12) angeordnet ist, wenigstens zwei in dem Gehäuseelement (12) angeordnete Hebelelemente (16), zumindest ein Schaltelement (28), welches schaltbar zwischen den wenigstens zwei Hebelelementen (16) und dem Tastenkappenelement (14) angeordnet ist, **dadurch gekennzeichnet, dass** das Bedienelement (10) zumindest ein zumindest teilweise elektrisch schaltbares erstes Funktionselement (20) umfasst und dass an den zwei Hebelelementen (16) zumindest ein zweites Funktionselement (22) angeordnet ist, wobei das zumindest das eine zumindest teilweise elektrisch schaltbare erste Funktionselement (20) mit dem zumindest einen zweiten Funktionselement (22) wirkverbunden ist, wobei eine Zustandsänderung in dem zumindest einem ersten Funktionselement (20) eine Zustandsänderung in dem zumindest einen zweiten Funktionselement (22) bewirkt, sodass mittels wenigstens einem der zwei Hebelelemente (16) bei einer äußeren Krafteinwirkung auf das Tastenkappenelement (14) das zumindest eine Schaltelement (28) von einer ersten Position in eine zweite Position benutzerdefiniert schaltbar ist.

2. Bedienelement (10) nach Anspruch 1, wobei die zwei Hebelelemente (16) wirkverbunden sind, sodass eine jeweilige Bewegung von einem Hebelelement (16) eine jeweilige Bewegung des anderen Hebelelements (16) bewirkt, wobei ein synchroner Bewegungsablauf der zwei Hebelelemente (16) erreichbar ist.

3. Bedienelement (10) nach einem der vorherigen Ansprüche, wobei das zumindest teilweise elektrisch schaltbare erste Funktionselement (20) ein Permanent-Elektromagnet ist.

4. Bedienelement (10) nach einem der Ansprüche 1 bis 2, wobei das zumindest teilweise elektrisch schaltbare erste Funktionselement (20) ein Elektromagnet ist.

5. Bedienelement (10) nach einem der Ansprüche 1 bis 2, wobei das zumindest teilweise elektrisch schaltbare erste Funktionselement (20) ein bistabiler Elektromagnet ist.

6. Bedienelement (10) nach einem der vorherigen Ansprüche, wobei das zumindest eine zweite Funktionselement (22) ein Permanentmagnet ist.

7. Bedienelement (10) nach einem der vorherigen Ansprüche 1 bis 5, wobei das zumindest eine zweite Funktionselement (22) zumindest teilweise aus einer Metalllegierung, insbesondere einer Metalllegierung zumindest Eisen umfassend, aufgebaut ist.

8. Bedienelement (10) nach einem der vorherigen Ansprüche 1 bis 5, wobei das zumindest eine zweite Funktionselement (22) in den jeweiligen Hebelelementen (16) mittels eines jeweiligen Aufhängeelementes (50) angeordnet ist und zumindest teilweise in das jeweilige erste Funktionselement (20) hineinragt.

9. Bedienelement (10) nach einem der vorherigen Ansprüche 1 bis 5, wobei das zumindest eine zweite Funktionselement (22) zumindest teilweise aus einer Metalllegierung, insbesondere einer Metalllegierung zumindest Eisen umfassend, aufgebaut ist und mittels eines Drehachsenelements (18) mit den zwei Hebelelementen (16) wirkverbunden ist, sodass ein Bewegungsimpuls von zumindest einem der zwei Hebelelemente (16) das zumindest eine zweite Funktionselement (22) derart bewegt, sodass bei einer äußeren Krafteinwirkung auf das Tastenkappenelement (14) das zumindest eine Schaltelement (28) von einer ersten Position in eine zweite Position mittels wenigstens einem der Hebelelemente (16) und des zweiten Funktionselements (22) benutzerdefiniert schaltbar ist.

10. Fahrzeug (58) mit zumindest einem Bedienelement (10) nach einem der vorherigen Ansprüche 1 bis 9.

## Claims

1. Operating element (10) for a motor vehicle, comprising a housing element (12); a key cap element (14) which is arranged on the housing element (12); at least two lever elements (16) arranged in the housing element (12); at least one switching element (28) which is arranged in a switchable manner between the at least two lever elements (16) and the key cap element (14), **characterized in that** the operating element (10) comprises at least one at least partially electrically switchable first functional element (20), and **in that** at least one second functional element (22) is arranged on the two lever elements (16), wherein the at least one at least partially electrically switchable first functional element (20) is operatively connected to the at least one second functional element (22), wherein a change in state in the at least one first functional element (20) causes a change in state in the at least one second functional element (22), so that at least one switching element (28) can be switched from a first position to a second position in a user-defined manner by means of at least one of the two lever elements (16) if an external force acts on the key cap element (14).

2. Operating element (10) according to claim 1, wherein the two lever elements (16) are operatively connected such that a respective movement of one lever element (16) causes a respective movement of the other lever element (16), wherein a synchronous movement sequence of the two lever elements (16) is achievable.

3. Operating element (10) according to one of the preceding claims, wherein the at least partially electrically switchable first functional element (20) is a permanent electromagnet.

4. Operating element (10) according to any one of claims 1 to 2, wherein the at least partially electrically switchable first functional element (20) is an electromagnet.

5. Operating element (10) according to any one of claims 1 to 2, wherein the at least partially electrically switchable first functional element (20) is a bistable electromagnet.

6. Operating element (10) according to any one of the preceding claims, wherein the at least one second functional element (22) is a permanent magnet.

7. Operating element (10) according to any one of the preceding claims 1 to 5, wherein the at least one second functional element (22) is at least partially constructed of a metal alloy, in particular a metal alloy comprising at least iron.

8. Operating element (10) according to any one of the preceding claims 1 to 5, wherein the at least one second functional element (22) is arranged in the respective lever elements (16) by means of a respective suspension element (50) and projects at least partially into the respective first functional element (20).

9. Operating element (10) according to any one of the preceding claims 1 to 5, wherein the at least one second functional element (22) is at least partially constructed of a metal alloy, in particular a metal alloy comprising at least iron, and is operatively connected to the two lever elements (16) by means of a rotational axis element (18), so that a movement pulse of at least one of the two lever elements (16) moves the at least one second functional element (22) such that, if an external force acts on the key cap element (14), the at least one switching element (28) can be switched in a user-defined manner from a first position to a second position by means of at least one of the lever elements (16) and the second functional element (22).

10. Vehicle (58) having at least one operating element (10) according to any one of claims 1 to 9.

## Revendications

1. Élément de commande (10) pour un véhicule automobile comprenant un élément de boîtier (12), un élément de capot (14), qui est agencé sur l'élément de boîtier (12), au moins deux éléments de levier (16) agencés dans l'élément de boîtier (12), au moins un élément de commutation (28), qui est agencé de manière à pouvoir commuter entre les au moins deux éléments de levier (16) et l'élément de capot (14), **caractérisé en ce que** l'élément de commande (10) comprend au moins un premier élément fonctionnel (20) au moins partiellement électriquement commutable et **en ce qu'**au moins un second élément fonctionnel (22) est agencé sur les deux éléments de levier (16), dans lequel l'au moins un premier élément fonctionnel (20) au moins partiellement électriquement commutable est en liaison fonctionnelle avec l'au moins un second élément fonctionnel (22), dans lequel un changement d'état dans l'au moins un premier élément fonctionnel (20) entraîne un changement d'état dans l'au moins un second élément fonctionnel (22), de sorte qu'au moyen d'au moins un des deux éléments de levier (16) lors de l'action d'une force extérieure sur l'élément de capot (14), l'au moins un élément de commutation (28) puisse être commuté d'une première position dans une seconde position, de manière définie par l'utilisateur.

2. Élément de commande (10) selon la revendication 1, dans lequel les deux éléments de levier (16) sont en liaison fonctionnelle, de sorte qu'un déplacement respectif d'un élément de levier (16) entraîne un déplacement respectif de l'autre élément de levier (16), dans lequel une séquence de déplacement synchrone des deux éléments de levier (16) peut être atteinte.

3. Élément de commande (10) selon l'une quelconque des revendications précédentes, dans lequel le premier élément fonctionnel au moins partiellement électriquement commutable (20) est un électroaimant permanent.

4. Élément de commande (10) selon l'une quelconque des revendications 1 à 2, dans lequel le premier élément fonctionnel au moins partiellement électriquement commutable (20) est un électroaimant.

5. Élément de commande (10) selon l'une quelconque des revendications 1 à 2, dans lequel le premier élément fonctionnel au moins partiellement électriquement commutable (20) est un électroaimant bistable.

6. Élément de commande (10) selon l'une quelconque des revendications précédentes, dans lequel l'au moins un second élément fonctionnel (22) est un aimant permanent.

7. Élément de commande (10) selon l'une quelconque des revendications 1 à 5, dans lequel l'au moins un second élément fonctionnel (22) est construit au moins partiellement à partir d'un alliage métallique, notamment un alliage métallique comprenant au moins du fer.

8. Élément de commande (10) selon l'une quelconque des revendications précédentes 1 à 5, dans lequel l'au moins un second élément fonctionnel (22) est agencé dans les éléments de levier respectifs (16) au moyen d'un élément de suspension respectif (50) et fait saillie au moins partiellement dans le premier élément fonctionnel respectif (20).

9. Élément de commande (10) selon l'une quelconque des revendications précédentes 1 à 5, dans lequel l'au moins un second élément fonctionnel (22) est construit au moins partiellement à partir d'un alliage métallique, notamment un alliage métallique comprenant au moins du fer et est en liaison fonctionnelle au moyen d'un élément d'axe de rotation (18) avec les deux éléments de levier (16), de sorte qu'une impulsion de déplacement d'au moins un des deux éléments de levier (16) déplace l'au moins un second élément fonctionnel (22) de sorte que lors de l'action d'une force extérieure sur l'élément de capot (14), l'au moins un élément de commutation (28) puisse être commuté d'une première position dans une seconde position au moyen d'au moins un des éléments de levier (16) et du second élément fonctionnel (22), de manière définie par l'utilisateur.

10. Véhicule (58) comprenant au moins un élément de commande (10) selon l'une quelconque des revendications précédentes 1 à 9.
